# EUROPEAN PATENT SPECIFICATION

(11) **EP 3 800 156 B1**
(45) Date of publication and mention of the grant of the patent: **05.03.2025**
(21) Application number: 20199338.3
(22) Date of filing: 30.09.2020
(51) Int. Cl.: B66B 11/02

(54) **COOLING SYSTEM FOR ELEVATOR CAR ELECTRONIC VISUAL DISPLAYS AND METHOD THEREOF**
KÜHLSYSTEM FÜR AUFZUGSKABINEN ELEKTRONISCHEN SICHTANZEIGEN UND VERFAHREN DAVON
SYSTÈME DE REFROIDISSEMENT POUR AFFICHAGES VISUELS ÉLECTRONIQUES DE CABINE D'ASCENSEUR ET SON PROCÉDÉ

(30) Priority: 04.10.2019 US 201916592813
(43) Date of publication of application: 07.04.2021
(73) Proprietor: Otis Elevator Company, Farmington, Connecticut 06032 (US)
(72) Inventor: DERWINSKI, Patricia, Farmington, CT Connecticut 06032 (US); CASTRO, Cuauhtemoc, Florence, SC South Carolina 29501 (US)
(74) Representative: Dehns

(56) References cited:
- EP-A1- 3 064 462
- WO-A1-2015/030435
- KR-A- 20120 055 910
- KR-A- 20150 031 664
- KR-A- 20160 029 413
- US-A- 2 350 389

## Description

### TECHNICAL FIELD

This invention relates to a cooling system for an elevator with electronic visual displays, and a corresponding method.

### BACKGROUND

Elevator cars are known to include electronic visual displays, which may be configured to display still images or videos to passengers. More recently, in buildings with destination landings, such as upper floor restaurants or observation decks, such electronic visual displays are used to display information about the building and/or the observation deck while the elevator car transports passengers to and from the observation deck. KR20120055910 A discloses an apparatus for radiating heat away from a display panel of an elevator. WO2015/030435 A1 and KR20150031664 A each disclose a ventilation means for discharging heat generated from a monitor supported on a wall of an elevator cage. All these documents disclose the preamble of claim 11.

### SUMMARY

According to a first aspect of the present invention there is provided an elevator system as defined by claim 1.

In a further non-limiting embodiment, the elevator system includes a plurality of sets of electronic visual displays and further includes a plurality of second flow paths, and each of the second flow paths is arranged adjacent to a respective one of the sets of electronic visual displays.

In a further non-limiting embodiment, each set of electronic visual displays includes a first electronic visual display mounted vertically above a second electronic visual display.

In a further non-limiting embodiment, the passenger space is interior of the sets of electronic visual displays.

In a further non-limiting embodiment, the gap is fluidly coupled to a source of fluid by a second flow path inlet arranged adjacent a bottom of the electronic visual display, and the gap is fluidly coupled to a location outside the elevator car by a second flow path outlet arranged adjacent a top of the electronic visual display.

In a further non-limiting embodiment, the second flow path inlet is vertically above the first flow path inlet.

In a further non-limiting embodiment, the second flow path outlet is vertically below the first flow path outlet.

In a further non-limiting embodiment, the system includes a second flow path inlet fan arranged adjacent the second flow path inlet and configured to direct fluid to the gap, and a second flow path outlet fan arranged adjacent the second flow path outlet and configured to draw fluid out of the gap.

In a further non-limiting embodiment, the elevator car includes a double-walled thickness including the inner wall and an outer wall spaced-apart from the inner wall, the second flow path inlet fan is at least partially arranged in a space between the inner wall and the outer wall, and the second flow path outlet fan is at least partially arranged in the space between the inner wall and the outer wall.

In a further non-limiting embodiment, the elevator system includes a temperature sensor configured to generate a signal indicative of a temperature of one of the electronic visual display and the passenger space, and a controller configured to selectively activate the second flow path inlet fan and the second flow path outlet fan in response to the signal.

In a further non-limiting embodiment, the elevator system includes a controller configured to selectively activate the second flow path inlet fan and the second flow path outlet fan when the electronic visual display is activated.

In a further non-limiting embodiment, the elevator car is in a building with an observation deck, and the electronic visual display is a screen configured to present at least one of images and video pertaining to the observation deck.

According to a second aspect of the present invention there is provided a method as defined by claim 11.

In a further non-limiting embodiment, the step of establishing a flow of fluid within the gap includes directing the fluid into the gap using an inlet fan.

In a further non-limiting embodiment, the method includes drawing air out of the gap using an outlet fan.

In a further non-limiting embodiment, the method includes activating the inlet fan and the outlet fan in response to a signal from a temperature sensor.

In a further non-limiting embodiment, the method includes activating the inlet fan and the outlet fan when the electronic visual display is activated.

The embodiments, examples and alternatives of the preceding paragraphs, the claims, or the following description and drawings, including any of their various aspects or respective individual features, may be taken independently or in any combination so far as they are within the scope of the appended claims. Features described in connection with one embodiment are applicable to all embodiments, unless such features are incompatible.

### BRIEF DESCRIPTION OF THE DRAWINGS

Figure 1 illustrates a portion of a passenger space of an example elevator car.
Figure 2 schematically illustrates a cooling system of the elevator car.
Figure 3 is a somewhat schematic, perspective view of a side wall of another example elevator car.
Figure 4 is a somewhat schematic cross-sectional view taken along line 4-4 in Figure 3.

### DETAILED DESCRIPTION

This invention relates to a cooling system for an elevator with electronic visual displays, and a corresponding method. An example system includes an elevator car having an inner wall, and an electronic visual display mounted to the inner wall so as to define a gap between the inner wall and the electronic visual display. Further, fluid is configured to flow through the gap to cool the electronic visual display. Among other benefits, which will be appreciated from the below description, this invention provides effective cooling for electronic visual displays within elevator cars, without being unduly large or expensive, and without drawing high power during operation. The system also simplifies maintenance and is scalable in terms of the number of fans, the size of the elevator car, and/or the number of electronic visual displays within the elevator car. Further, the system is low-noise and produces minimal, if any, condensation.

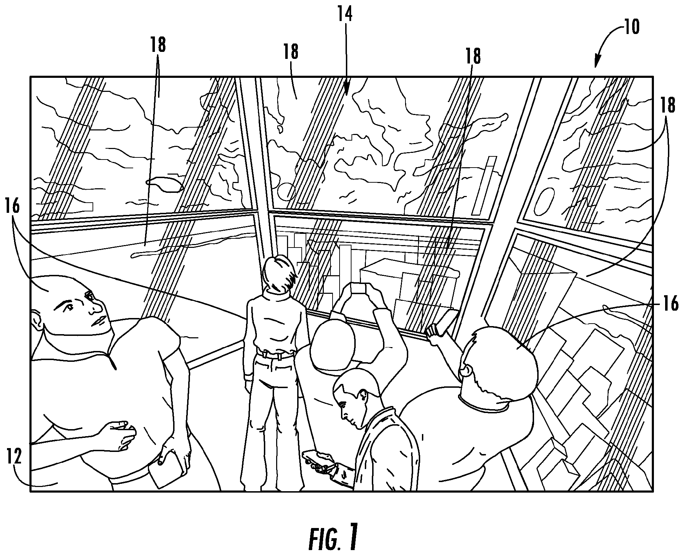

Figure 1 illustrates an example elevator system 10, and in particular illustrates a portion of a passenger space 12 (i.e., passenger cabin) of an elevator car 14. The elevator system 10, in this example, is located in a building with a destination landing, such as an upper floor restaurant or an observation deck. In the example, the elevator car 14 is configured to travel within a hoistway to transport passengers 16 to and from a lobby of the building and the observation deck. While observation decks are mentioned herein, this invention is not limited to elevator systems used in buildings with observation decks, and extends to other elevator systems with electronic visual displays including those intended to provide passengers with an immersive media experience.

In the example of Figure 1, a plurality of passengers 16 are traveling between a lobby and an observation deck. The elevator car 14, in this example, includes a plurality of electronic visual displays 18. The electronic visual displays 18 are arranged relative to one another such that, collectively, the electronic visual displays 18 substantially cover the entirety of the inner walls of the elevator car 14. As such, the electronic visual displays 18 can provide the passengers 16 with an immersive media experience. While a plurality of electronic visual displays are shown in Figure 1, it should be understood that this invention extends to elevator cars with one or more electronic visual displays. Further, while electronic visual displays 18 are shown on three different walls of the elevator car 14 in Figure 1, this invention extends to elevator systems with at least one electronic visual display on at least one wall of an elevator car. The invention separately applies to elevator systems with one or more electronic visual displays on a ceiling of the elevator car.

In one example, the electronic visual displays 18 display information about the observation deck to the passengers 16 as they are transported to or from the observation deck. For instance, the electronic visual displays 18 can be used to display an informative video to the passengers 16. The video may include information about the observation deck such as the height of the observation deck, current weather, visibility, visible landmarks, history of the building, and other information. This invention is not limited to electronic visual display that play videos that pertain to observation decks, however. The electronic visual displays 18 could display other content such as still images, videos, advertisements, etc. The electronic visual displays 18 could present other types of media.

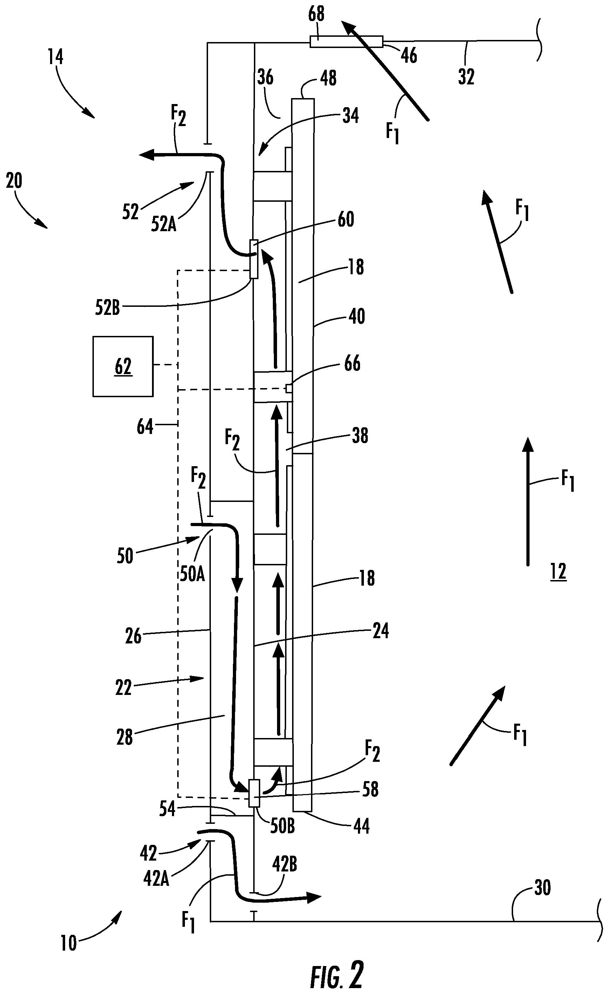

Figure 2 is a schematic, cross-sectional view of the elevator system 10, and in particular illustrates a cooling system 20 of the elevator car 14. In this invention, the cooling system 20 is configured to direct air in a manner that cools the electronic visual displays 18.

The elevator car 14 includes side walls 22 with a shell having a double-walled thickness. One of the side walls 22 is shown in Figure 2. While a double-walled thickness shell including two spaced-apart panels is shown in Figure 2, this invention extends to side walls having a single-walled thickness shell.

In particular, the side walls 22 each have a double-walled thickness shell provided by an inner wall 24 and an outer wall 26 spaced-apart from the inner wall 24 in a horizontal direction by a space 28. The space 28 is a substantially hollow space in this example. The space 28 may also be at least partially filled with noise attenuating material. In the example of a single-walled thickness shell, other noise attenuating features such as baffles may be incorporated into the shell.

The inner and outer walls 24, 26 are panels, in this example, and extend from a floor 30 of the elevator car 14 to a ceiling 32. Together, the inner walls 24, floor 30, and ceiling 32 define the passenger space 12. Alternatively, there may be decorative panels below the ceiling 32 and/or above the floor 30 which partially define the passenger space 12.

The electronic visual displays 18 are mounted to the inner walls 24, in this example, by way of mounting brackets 34. The mounting brackets 34 are directly attached to both the inner walls 24 and the electronic visual displays 18. The electronic visual displays 18 are mounted such that a back surface 36 of the electronic visual displays 18 faces the inner wall 24 and is spaced-apart from the inner wall 24 so as to define a gap 38 between the inner wall 24 and the electronic visual display 18. In Figure 2, there are two electronic visual displays 18, with one mounted vertically above another to provide a vertical set of electronic visual displays. While two electronic visual displays 18 are shown vertically arranged relative to one another herein, it should be understood that other electronic visual display arrangements are contemplated by this invention. For instance, the two electronic visual displays 18 could be replaced with a single, relatively taller electronic visual display. Alternatively, there could be three or more vertically stacked electronic visual displays 18.

Front surfaces 40 of the electronic visual displays 18, which include a screen, face toward the center of the elevator car 14. The mounting brackets 34 may include vertical and horizontal bracket components. This invention is not limited to any particular type of mounting bracket.

The electronic visual displays 18 typically generate and emit heat during use. This invention provides a cooling system 20 configured to cool the electronic visual displays 18. In a particular embodiment, fluid is configured to flow through the gap 38 to cool the electronic visual displays 18. The fluid is air, in one example, and thus this invention may referred to as a forced air cooling system. As will be appreciated from the below, a particular aspect of this invention provides two independent fluid flow paths, one of which is configured to direct fluid to cool the passenger space 12 and one of which is configured to direct fluid through the gap 38 to cool the electronic visual displays 18.

Specifically, cooling system 20 includes a first flow path through which fluid F₁ is configured to flow to cool the passenger space 12. In particular, the passenger space 12 is fluidly coupled to a source of fluid F₁ by a first flow path inlet 42 configured to direct fluid F₁ into the passenger space 12 beneath the electronic visual displays 18. The first flow path inlet 42 includes a first port 42A in outer wall 26 and a second port 42B in inner wall 24 and arranged vertically beneath the first port 42A. The first port 42A is fluidly coupled to air within a hoistway, in one example, and fluid F₁ is configured to flow between the first and second ports 42A, 42B within the space 28. The second port 42B is arranged vertically below a bottom-most edge 44 of a bottom one of the electronic visual displays 18 such that fluid F₁ may flow to the passenger space 12. The fluid F₁ cools the passenger space 12 by directing hot air out an outlet 46 in the ceiling 32, in this example. The outlet 46 is above a top-most edge 48 of a top one of the electronic visual displays 18. The outlet 46 does not need to be in the ceiling 32 in all examples, and could be in an upper section of the side wall 22, for example. The outlet 46 could include a fan 68 configured to direct fluid out of the passenger space 12, in some examples.

The cooling system 20 also includes a second flow path through which fluid F₂ is configured to flow to cool the electronic visual displays 18. The fluids F₁, F₂ may both be air and may both be sourced from a hoistway. The fluids F₁, F₂ may be sourced from locations other than the hoistway, however. The fluids are referred to separately herein because they are directed through different flow paths.

The gap 38 is fluidly coupled to the fluid F₂ by a second flow path inlet 50, which includes a port 50A in the outer wall 26 and a port 50B in the inner wall 24 arranged vertically below the port 50A. The second flow path inlet 50 is vertically above the first flow path inlet 42. Fluid F₂ is configured to flow in the space 28 between the port 50A and 50B. The port 50B is arranged adjacent, and in this example slightly above, the bottom-most edge 44 of the bottom electronic visual display 18. As such, fluid F₂ exiting the port 50B flows vertically upward through the gap 38 and cools the electronic visual displays 18 by directing hot air away from the electronic visual displays 18.

The fluid F₂ flows vertically upward toward a second flow path outlet 52, which includes port 52A in the outer wall 26 and port 52B in the inner wall 24. The port 52B is arranged vertically below the port 52A and is arranged adjacent, and in this example slightly below, the upper-most edge 48 of the upper electronic visual display 18. The second flow path outlet 52 is vertically below the first flow path outlet 46.

The side wall 22 includes two partitions, in this example, to prevent mixing of the various flows of fluid. A first partition 54 extends horizontally between the inner wall 24 and the outer wall 26 and is arranged below the port 50B to prevent the fluid F₂ from mixing with fluid F₁. A second partition 56 extends horizontally between the inner wall 24 and the outer wall 26 and is arranged above the port 50A to prevent the fluid F₂ adjacent the second flow path inlet 50, which is relatively cooler, from mixing with fluid F₂ adjacent the outlet 52, which is relatively hotter.

The partitions 54, 56 divide the side wall 22 into three vertical sections in this example. The first section provides first flow path inlet 42 and extends from the floor 30 to the first partition 54, which is at about knee height of an average-height passenger. The second section provides the second flow path inlet 50 and extends vertically between the first partition 54 and the second partition 56, which is at about waist height. The third section provides the second flow path outlet 52 and extends from the second partition 56 to the ceiling 32.

In one example, the flow of fluid F₂ is established (i.e., introduced) within the second flow path by passively flowing from the second flow path inlet 50 to the second flow path outlet 52 without being forced by a fan. In another example, the cooling system 20 includes at least one fan (e.g., one at the inlet, one at the outlet, or both) configured to actively establish the flow of fluid F₂ through the second flow path. While fans are illustrated relative to the second flow path, it should be understood that one or more fans (e.g., fan 68) could also be used relative to the first flow path in order to actively establish the flow of fluid F₁. Alternatively, the flow of fluid F₁ may be established passively.

In the example of Figure 2, the cooling system 20 includes a second flow path inlet fan 58 arranged adjacent the second flow path inlet 50 and configured to direct fluid F₂ into the gap 38. The cooling system 20 further includes a second flow path outlet fan 60 arranged adjacent the second flow path outlet 52 and configured to draw, and exhaust, fluid F₂ out of the gap 38. The fans 58, 60 are shown schematically in Figure 2. In this example, the second flow path inlet fan 58 is mounted in the port 50B and is at least partially arranged in the space 28 between the inner wall 24 and the outer wall 26. The second flow path outlet fan 60 is mounted in the port 52B and is at least partially arranged in the space 28. Thus, the fans 58, 60 are at least partially recessed into the side wall 22. The fans 58, 60 may be fully recessed in other examples. In those examples, the fans 58, 60 are completely within the space 28. The fans 58, 60 may also be mounted to the outer wall 26 in examples where it is not possible to mount fans to the inner wall 24.

The fans 58, 60 are electronically connected to a controller 62, and the fans 58, 60 are selectively activated in response to instructions from the controller 62. The controller 62 is shown schematically in Figure 2. The controller 62 includes electronics, software, or both, to perform the necessary control functions. In one non-limiting embodiment, the controller 62 is an elevator drive controller. Although it is shown as a single device, the controller 62 may include multiple controllers in the form of multiple hardware devices, or multiple software controllers within one or more hardware devices. A controller area network (CAN) 64, illustrated schematically, allows the controller 62 to communicate with various components of the elevator system 10 by wired and/or wireless electronic connections.

In one aspect of this invention, the controller 62 is electronically connected to a temperature sensor 66. In Figure 2, a single temperature sensor 66 is shown. The temperature sensor 66 is mounted adjacent one of the electronic visual displays 18 and is configured to generate a signal indicative of a temperature of the electronic visual displays 18. Additional temperature sensors may be mounted to other electronic visual displays 18. The temperature sensor 66 may alternatively be mounted adjacent the passenger space 12 and be configured to generate a signal indicative of a temperature of the passenger space 12. The controller 62 is configured to selectively activate the fans 58, 60 in response to the signal(s) from the temperature sensor(s). In another example, there are no temperature sensors, and instead the controller 62 activates the fans 58, 60 when the electronic visual displays 18 are activated (i.e., turned on). The controller 62 may also independently activate a fan 68 arranged in outlet 46 based on information from one or more of the temperature sensors, for example.

As mentioned above, the elevator system 10 may include a plurality of electronic visual displays 18. The electronic visual displays 18 may be arranged in vertical sets, with each vertical set including a plurality of electronic visual displays arranged vertically one over the other. Figure 2 illustrates one such vertical set, and thus includes one second flow path. It should be understood that the cooling system 20 may include additional second flow paths. Specifically, the cooling system 20 may include one second flow path, substantially similar to the one shown in Figure 2, arranged adjacent each vertical set of electronic visual displays. When there are additional second flow paths, the additional fans may be electronically connected in series (i.e., daisy chained) in order to reduce bulky electrical harnesses.

The cooling system 20 may further include various seals and partitions configured to keep the fluid F₂ within the gap 38 and prevent mixing of the fluids F₁, F₂. The seals and partitions may extend between adjacent electronic visual displays 18, between the inner wall 24 and the electronic visual displays, etc. In one example, the seals and partitions may be provided in part by the mounting brackets 34, various gaskets, and/or other structures such as baffles.

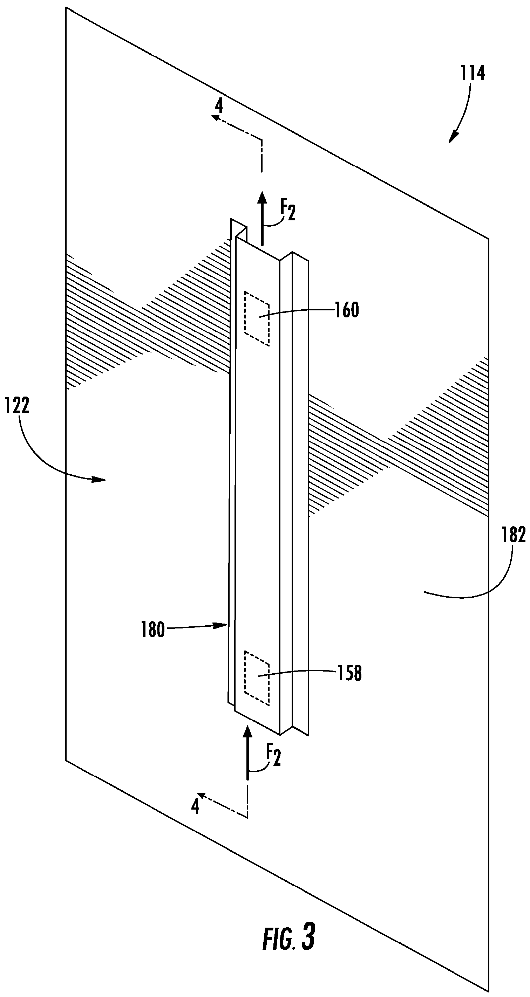

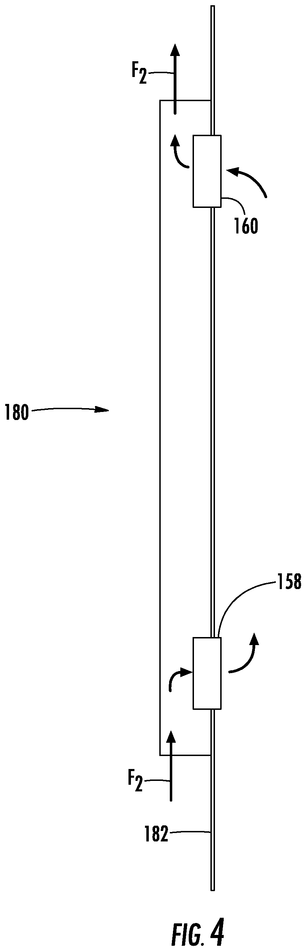

Figures 3 and 4 illustrate another aspect of the present invention. Figures 3 and 4 illustrate an elevator car 114 similar to the elevator car 14 with like reference numerals pre-appended with a "1." Figures 3 and 4 do not show any electronic visual displays, although they would be arranged similar to the previous embodiment. Figure 3 and 4 also only show the second flow path. It should be understood that the first flow path would be arranged similarly to the embodiment of Figure 2.

The elevator car 114 includes a single-thickness shell side wall 122. In Figure 3, there is a vertically-arranged baffle 180 on an outer surface 182 of the side wall 122. The outer surface 182 in this example faces the hoistway. The baffle 180 allows fluid such as the fluid F₂ to enter and exit at the axial ends of the baffle 180. In this example, the baffle 180 covers fans 158 and 160 and provides protection relative to the fans similar to that which is provided by the outer wall 26 in the previously discussed embodiment. The baffle 180 also attenuates noise and permits fluid to flow in a desired direction. While only one baffle 180 is illustrated in Figures 3 and 4, the side wall 122 may incorporate a number of similarly-arranged baffles. Further, the baffle 180 may be used in the embodiment of Figure 2 to attenuate noise and cover the inlets and/or outlets 42, 50, 52. The baffle 180 may be used when retrofitting existing elevator cars with a system as described herein.

It should be understood that terms such as "generally," "substantially," and "about" are not intended to be boundary less terms, and should be interpreted consistent with the way one skilled in the art would interpret those terms. Further, directional terms such as "vertical," "horizontal," "above," and "below" are used consistent with their plain and ordinary meanings with reference to the normal operational attitude of an elevator car and should not otherwise be considered limiting.

Although the different examples have the specific components shown in the illustrations, embodiments of this invention are not limited to those particular combinations. It is possible to use some of the components or features from one of the examples in combination with features or components from another one of the examples so far as it is within the scope of the appended claims. In addition, the various figures accompanying this invention are not necessarily to scale, and some features may be exaggerated or minimized to show certain details of a particular component or arrangement.

One of ordinary skill in this art would understand that the above-described embodiments are exemplary and non-limiting. That is, modifications of this invention would come within the scope of the claims. Accordingly, the following claims should be studied to determine their true scope and content.

## Claims

1. An elevator system (10), comprising:
an elevator car (14, 114) having an inner wall (22, 24, 122) and a passenger space (12); and
an electronic visual display (18) mounted to the inner wall (22, 24, 122) so as to define a gap (38) between the inner wall (22, 24, 122) and the electronic visual display (18), wherein fluid (F₂) is configured to flow through the gap (38) to cool the electronic visual display (18);
a first flow path through which fluid (F₁) is configured to flow to cool the passenger space (12); and
a second flow path through which fluid (F₂) is configured to flow to cool the electronic visual display (18); wherein
the passenger space (12) is fluidly coupled to a source of fluid by a first flow path inlet (42) configured to direct fluid (F₁) into the passenger space (12) beneath the electronic visual display (18), and
the passenger space (12) is fluidly coupled to a location outside the elevator car (14, 114) by a first flow path outlet (46) arranged above the electronic visual display (18).

2. The elevator system (10) as recited in claim 1, wherein:
the elevator system (10) includes a plurality of sets of electronic visual displays (18) and further includes a plurality of second flow paths, and
each of the second flow paths is arranged adjacent to a respective one of the sets of electronic visual displays (18).

3. The elevator system (10) as recited in claim 2, wherein each set of electronic visual displays (18) includes a first electronic visual display (18) mounted vertically above a second electronic visual display (18) and/or wherein the passenger space (12) is interior of the sets of electronic visual displays (18).

4. The elevator system (10) as recited in any preceding claim, wherein:
the gap (38) is fluidly coupled to a source of fluid (F₂) by a second flow path inlet (50; 50B) arranged adjacent a bottom of the electronic visual display (18), and
the gap (38) is fluidly coupled to a location outside the elevator car (14, 114) by a second flow path outlet (52; 52B) arranged adjacent a top of the electronic visual display (18).

5. The elevator system (10) as recited in claim 4, wherein the second flow path inlet (50; 50B) is vertically above the first flow path inlet (42) and/or wherein the second flow path outlet (52; 52B) is vertically below the first flow path outlet (46).

6. The elevator system (10) as recited in any preceding claim, further comprising:
a second flow path inlet fan (58, 158) arranged adjacent the second flow path inlet (50; 50B) and configured to direct fluid to the gap (38); and
a second flow path outlet fan (60, 160) arranged adjacent the second flow path outlet (52; 52B) and configured to draw fluid out of the gap (38).

7. The elevator system (10) as recited in claim 6, wherein:
the elevator car (14) includes a double-walled thickness including the inner wall (24) and an outer wall (26) spaced-apart from the inner wall (24),
the second flow path inlet fan (58) is at least partially arranged in a space between the inner wall (24) and the outer wall (26), and
the second flow path outlet fan (60) is at least partially arranged in the space between the inner wall (24) and the outer wall (26).

8. The elevator system (10) as recited in claim 6 or 7, further comprising:
a temperature sensor (66) configured to generate a signal indicative of a temperature of one of the electronic visual display (18) and the passenger space (12); and
a controller (62) configured to selectively activate the second flow path inlet fan (58, 158) and the second flow path outlet fan (60, 160) in response to the signal.

9. The elevator system (10) as recited in any one of claims 6, 7 or 8, further comprising:
a controller (62) configured to selectively activate the second flow path inlet fan (58, 158) and the second flow path outlet fan (60, 160) when the electronic visual display (18) is activated.

10. The elevator system (10) as recited in any preceding claim, wherein:
the elevator car (14, 114) is in a building with an observation deck, and
the electronic visual display (18) is a screen (18) configured to present at least one of images and video pertaining to the observation deck.

11. A method, comprising:
establishing a flow of fluid (F₂) within a gap (38) between an inner wall (22; 24, 122) of an elevator car (14, 114) and an electronic visual display (18) mounted to the inner wall (22; 24, 122); **characterized in that** the method further comprises:
establishing a flow of fluid (F₁) into a passenger space (12) of the elevator car (14, 114) independent of the flow of fluid (F₂) within the gap (38); wherein
the passenger space (12) is fluidly coupled to a source of fluid by a first flow path inlet (42) configured to direct fluid (F₁) into the passenger space (12) beneath the electronic visual display (18), and
the passenger space (12) is fluidly coupled to a location outside the elevator car (14, 114) by a first flow path outlet (46) arranged above the electronic visual display (18).

12. The method as recited in claim 11, further comprising the step of establishing a flow of fluid (F₂) within the gap (38) includes directing the fluid into the gap (38) using an inlet fan (58, 158).

13. The method as recited in claim 12, further comprising drawing air out of the gap (38) using an outlet fan (60, 160) and optionally further comprising:
activating the inlet fan (58, 158) and the outlet fan (60, 160) in response to a signal from a temperature sensor (66); and/or
activating the inlet fan (58, 158) and the outlet fan (60, 160) when the electronic visual display (18) is activated.

## Patentansprüche

1. Aufzugssystem (10), umfassend:
eine Aufzugskabine (14, 114), die eine Innenwand (22, 24, 122) und einen Fahrgastraum (12) aufweist; und
eine elektronische Sichtanzeige (18), die an der Innenwand (22, 24, 122) angebracht ist, um einen Spalt (38) zwischen der Innenwand (22, 24, 122) und der elektronischen Sichtanzeige (18) zu definieren, wobei Fluid (F₂) dazu konfiguriert ist, durch den Spalt (38) zu strömen, um die elektronische Sichtanzeige (18) zu kühlen;
einen ersten Strömungsweg, durch den Fluid (F₁) konfigurationsgemäß strömen kann, um den Fahrgastraum (12) zu kühlen; und
einen zweiten Strömungsweg, durch den Fluid (F₂) konfigurationsgemäß strömen kann, um die elektronische Sichtanzeige (18) zu kühlen; wobei
der Fahrgastraum (12) durch einen ersten Strömungswegeinlass (42), der dazu konfiguriert ist, Fluid (F₁) in den Fahrgastraum (12) unterhalb der elektronischen Sichtanzeige (18) zu leiten, an eine Fluidquelle fluidgekoppelt ist, und
der Fahrgastraum (12) durch einen ersten Strömungswegauslass (46), der über der elektronischen Sichtanzeige (18) angeordnet ist, an eine Stelle außerhalb der Aufzugskabine (14, 114) fluidgekoppelt ist.

2. Aufzugssystem (10) nach Anspruch 1, wobei:
das Aufzugssystem (10) eine Vielzahl von Sätzen von elektronischen Sichtanzeigen (18) beinhaltet und ferner eine Vielzahl von zweiten Strömungswegen beinhaltet, und
jeder der zweiten Strömungswege benachbart zu einem jeweiligen der Sätze von elektronischen Sichtanzeigen (18) angeordnet ist.

3. Aufzugssystem (10) nach Anspruch 2, wobei jeder Satz von elektronischen Sichtanzeigen (18) eine erste elektronische Sichtanzeige (18) beinhaltet, die vertikal über einer zweiten elektronischen Sichtanzeige (18) angebracht ist, und/oder wobei der Fahrgastraum (12) innerhalb der Sätze von elektronischen Sichtanzeigen (18) liegt.

4. Aufzugssystem (10) nach einem der vorhergehenden Ansprüche, wobei:
der Spalt (38) durch einen zweiten Strömungswegeinlass (50; 50B), der benachbart zu einer Unterseite der elektronischen Sichtanzeige (18) angeordnet ist, an eine Quelle von Fluid (F₂) fluidgekoppelt ist, und
der Spalt (38) durch einen zweiten Strömungswegauslass (52; 52B), der benachbart zu einer Oberseite der elektronischen Sichtanzeige (18) angeordnet ist, an eine Stelle außerhalb der Aufzugskabine (14, 114) fluidgekoppelt ist.

5. Aufzugssystem (10) nach Anspruch 4, wobei der zweite Strömungswegeinlass (50; 50B) vertikal über dem ersten Strömungswegeinlass (42) liegt und/oder wobei der zweite Strömungswegauslass (52; 52B) vertikal unter dem ersten Strömungswegauslass (46) liegt.

6. Aufzugssystem (10) nach einem der vorhergehenden Ansprüche, ferner umfassend:
einen zweiten Strömungswegeinlasslüfter (58, 158), der benachbart zu dem zweiten Strömungswegeinlass (50; 50B) angeordnet und dazu konfiguriert ist, Fluid zu dem Spalt (38) zu leiten; und
einen zweiten Strömungswegauslasslüfter (60, 160), der benachbart zu dem zweiten Strömungswegauslass (52; 52B) angeordnet und dazu konfiguriert ist, Fluid aus dem Spalt (38) zu saugen.

7. Aufzugssystem (10) nach Anspruch 6, wobei:
die Aufzugskabine (14) eine doppelwandige Dicke beinhaltet, die die Innenwand (24) und eine von der Innenwand (24) beabstandete Außenwand (26) beinhaltet,
der zweite Strömungswegeinlasslüfter (58) zumindest teilweise in einem Raum zwischen der Innenwand (24) und der Außenwand (26) angeordnet ist und
der zweite Strömungswegauslasslüfter (60) zumindest teilweise in dem Raum zwischen der Innenwand (24) und der Außenwand (26) angeordnet ist.

8. Aufzugssystem (10) nach Anspruch 6 oder 7, ferner umfassend:
einen Temperatursensor (66), der dazu konfiguriert ist, ein Signal zu generieren, das eine Temperatur eines von der elektronischen Sichtanzeige (18) und dem Fahrgastraum (12) angibt; und
eine Steuerung (62), die dazu konfiguriert ist, den zweiten Strömungswegeinlasslüfter (58, 158) und den zweiten Strömungswegauslasslüfter (60, 160) in Reaktion auf das Signal selektiv anzuschalten.

9. Aufzugssystem (10) nach einem der Ansprüche 6, 7 oder 8, ferner umfassend:
eine Steuerung (62), die dazu konfiguriert ist, den zweiten Strömungswegeinlasslüfter (58, 158) und den zweiten Strömungswegauslasslüfter (60, 160) selektiv anzuschalten, wenn die elektronische Sichtanzeige (18) angeschaltet ist.

10. Aufzugssystem (10) nach einem der vorhergehenden Ansprüche, wobei:
die Aufzugskabine (14, 114) sich in einem Gebäude mit einer Aussichtsplattform befindet und
die elektronische Sichtanzeige (18) ein Bildschirm (18) ist, der dazu konfiguriert ist, mindestens eines von Bildern und Video, die die Aussichtsplattform betreffen, darzustellen.

11. Verfahren, umfassend:
Herstellen eines Stroms von Fluid (F₂) innerhalb eines Spalts (38) zwischen einer Innenwand (22; 24, 122) einer Aufzugskabine (14, 114) und einer an der Innenwand (22; 24, 122) angebrachten elektronischen Sichtanzeige (18); **dadurch gekennzeichnet, dass** das Verfahren ferner Folgendes umfasst:
Herstellen eines Stroms von Fluid (F₁) in einen Fahrgastraum (12) der Aufzugskabine (14, 114) unabhängig von dem Strom von Fluid (F₂) innerhalb des Spalts (38); wobei
der Fahrgastraum (12) durch einen ersten Strömungswegeinlass (42), der dazu konfiguriert ist, Fluid (F₁) in den Fahrgastraum (12) unterhalb der elektronischen Sichtanzeige (18) zu leiten, an eine Fluidquelle fluidgekoppelt ist, und
der Fahrgastraum (12) durch einen ersten Strömungswegauslass (46), der über der elektronischen Sichtanzeige (18) angeordnet ist, an eine Stelle außerhalb der Aufzugskabine (14, 114) fluidgekoppelt ist.

12. Verfahren nach Anspruch 11, ferner umfassend, dass der Schritt des Herstellens eines Stroms von Fluid (F₂) innerhalb des Spalts (38) Leiten des Fluids in den Spalt (38) unter Verwendung eines Einlasslüfters (58, 158) beinhaltet.

13. Verfahren nach Anspruch 12, ferner umfassend Saugen von Luft aus dem Spalt (38) unter Verwendung eines Auslasslüfters (60, 160) und optional ferner umfassend:
Anschalten des Einlasslüfters (58, 158) und des Auslasslüfters (60, 160) als Reaktion auf ein Signal von einem Temperatursensor (66); und/oder
Anschalten des Einlasslüfters (58, 158) und des Auslasslüfters (60, 160), wenn die elektronische Sichtanzeige (18) angeschaltet ist.

## Revendications

1. Système d'ascenseur (10), comprenant :
une cabine d'ascenseur (14, 114) comportant une paroi interne (22, 24, 122) et un espace passagers (12) ; et
un affichage visuel électronique (18) monté sur la paroi interne (22, 24, 122) de sorte à délimiter un intervalle (38) entre la paroi interne (22, 24, 122) et l'affichage visuel électronique (18), dans lequel un fluide (F₂) est conçu pour s'écouler à travers l'espace (38) pour refroidir l'affichage visuel électronique (18) ;
un premier trajet d'écoulement à travers lequel le fluide (F₁) est conçu pour s'écouler afin de refroidir l'espace passagers (12) ; et
un second trajet d'écoulement à travers lequel le fluide (F₂) est conçu pour s'écouler afin de refroidir l'affichage visuel électronique (18) ; dans lequel
l'espace passagers (12) est accouplé fluidiquement à une source de fluide par une première entrée de trajet d'écoulement (42) conçue pour diriger le fluide (F₁) à l'intérieur de l'espace passagers (12) sous l'affichage visuel électronique (18), et
l'espace passagers (12) est accouplé fluidiquement à un emplacement à l'extérieur de la cabine d'ascenseur (14, 114) par une première sortie de trajet d'écoulement (46) agencée au-dessus de l'affichage visuel électronique (18).

2. Système d'ascenseur (10) selon la revendication 1, dans lequel :
le système d'ascenseur (10) comprend une pluralité d'ensembles d'affichages visuels électroniques (18) et comprend en outre une pluralité de seconds trajets d'écoulement, et
chacun des seconds trajets d'écoulement est agencé de manière adjacente à un affichage respectif parmi les ensembles d'affichages visuels électroniques (18).

3. Système d'ascenseur (10) selon la revendication 2, dans lequel chaque ensemble d'affichages visuels électroniques (18) comprend un premier affichage visuel électronique (18) monté à la verticale au-dessus d'un second affichage visuel électronique (18) et/ou dans lequel l'espace passagers (12) se trouve à l'intérieur des ensembles d'affichages visuels électroniques (18).

4. Système d'ascenseur (10) selon une quelconque revendication précédente, dans lequel :
l'intervalle (38) est accouplé fluidiquement à une source de fluide (F₂) par une seconde entrée de trajet d'écoulement (50 ;
50B) agencée de manière adjacente à un fond de l'affichage visuel électronique (18), et
l'intervalle (38) est accouplé fluidiquement à un emplacement à l'extérieur de la cabine d'ascenseur (14, 114) par une seconde sortie de trajet d'écoulement (52 ; 52B) agencée de manière adjacente à un haut de l'affichage visuel électronique (18).

5. Système d'ascenseur (10) selon la revendication 4, dans lequel la seconde entrée de trajet d'écoulement (50 ; 50B) est verticalement au-dessus de la première entrée de trajet d'écoulement (42) et/ou dans lequel la seconde sortie de trajet d'écoulement (52 ; 52B) est verticalement au-dessous de la première sortie de trajet d'écoulement (46).

6. Système d'ascenseur (10) selon une quelconque revendication précédente, comprenant également :
un second ventilateur d'entrée de trajet d'écoulement (58, 158) agencé de manière adjacente à la seconde entrée de trajet d'écoulement (50 ; 50B) et conçu pour diriger le fluide vers l'intervalle (38) ; et
un second ventilateur de sortie de trajet d'écoulement (60, 160) agencé de manière adjacente à la seconde sortie de trajet d'écoulement (52 ; 52B) et conçu pour aspirer le fluide hors de l'intervalle (38).

7. Système d'ascenseur (10) selon la revendication 6, dans lequel :
la cabine d'ascenseur (14) comprend une épaisseur à double paroi comprenant la paroi interne (24) et une paroi externe (26) espacée de la paroi interne (24),
le second ventilateur d'entrée de trajet d'écoulement (58) est agencé au moins en partie dans un espace entre la paroi interne (24) et la paroi externe (26), et
le second ventilateur de sortie de trajet d'écoulement (60) est agencé au moins en partie dans l'espace entre la paroi interne (24) et la paroi externe (26).

8. Système d'ascenseur (10) selon la revendication 6 ou 7, comprenant également :
un capteur de température (66) conçu pour générer un signal indiquant une température de l'un parmi l'affichage visuel électronique (18) et l'espace passagers (12) ; et
un dispositif de commande (62) conçu pour activer sélectivement le second ventilateur d'entrée de trajet d'écoulement (58, 158) et le second ventilateur de sortie de trajet d'écoulement (60, 160) en réponse au signal.

9. Système d'ascenseur (10) selon l'une quelconque des revendications 6, 7 ou 8, comprenant également :
un dispositif de commande (62) conçu pour activer sélectivement le second ventilateur d'entrée de trajet d'écoulement (58, 158) et le second ventilateur de sortie de trajet d'écoulement (60, 160) lorsque l'affichage visuel électronique (18) est activé.

10. Système d'ascenseur (10) selon une quelconque revendication précédente, dans lequel :
la cabine d'ascenseur (14, 114) se trouve dans un bâtiment doté d'une plate-forme d'observation, et
l'affichage visuel électronique (18) est un écran (18) conçu pour présenter au moins l'un parmi des images et une vidéo concernant la plate-forme d'observation.

11. Procédé, comprenant :
l'établissement d'un écoulement de fluide (F₂) à l'intérieur d'un intervalle (38) entre une paroi interne (22 ; 24, 122) d'une cabine d'ascenseur (14, 114) et un affichage visuel électronique (18) monté sur la paroi interne (22 ; 24, 122) ;
**caractérisé en ce que** le procédé comprend également :
l'établissement d'écoulement de fluide (F₁) à l'intérieur d'un espace passagers (12) de la cabine d'ascenseur (14, 114) indépendamment de l'écoulement de fluide (F₂) à l'intérieur de l'intervalle (38) ; dans lequel
l'espace passagers (12) est accouplé fluidiquement à une source de fluide par une première entrée de trajet d'écoulement (42) conçue pour diriger le fluide (F₁) à l'intérieur de l'espace passagers (12) sous l'affichage visuel électronique (18), et
l'espace passagers (12) est accouplé fluidiquement à un emplacement à l'extérieur de la cabine d'ascenseur (14, 114) par une première sortie de trajet d'écoulement (46) agencée au-dessus de l'affichage visuel électronique (18).

12. Procédé selon la revendication 11, comprenant également l'étape consistant à établir un écoulement de fluide (F₂) à l'intérieur de l'intervalle (38) comprenant la direction du fluide à l'intérieur de l'intervalle (38) à l'aide d'un ventilateur d'entrée (58, 158).

13. Procédé selon la revendication 12, comprenant également l'aspiration de l'air hors de l'intervalle (38) à l'aide d'un ventilateur de sortie (60, 160) et comprenant également éventuellement :
l'activation du ventilateur d'entrée (58, 158) et du ventilateur de sortie (60, 160) en réponse à un signal en provenance d'un capteur de température (66) ; et/ou
l'activation du ventilateur d'entrée (58, 158) et du ventilateur de sortie (60, 160) lorsque l'affichage visuel électronique (18) est activé.
